Europäisches Patentamt

European Patent Office

Office européen des brevets

(11) Veröffentlichungsnummer : **0 048 406**
**B1**

# (12) EUROPÄISCHE PATENTSCHRIFT

(45) Veröffentlichungstag der Patentschrift :
26.04.89

(51) Int. Cl.⁴ : **H 05 K   1/05**

(21) Anmeldenummer : **81107154.7**

(22) Anmeldetag : **10.09.81**

(54) **Wärmeableitende Leiterplatten.**

(30) Priorität : **22.09.80 DE 3035749**

(43) Veröffentlichungstag der Anmeldung :
**31.03.82 Patentblatt 82/13**

(45) Bekanntmachung des Hinweises auf die Patenterteilung : **26.04.89 Patentblatt 89/17**

(84) Benannte Vertragsstaaten :
**DE FR IT**

(56) Entgegenhaltungen :
**DE—A— 1 809 919**
**DE—A— 2 122 610**

(73) Patentinhaber : **Siemens Aktiengesellschaft Berlin
und München**
**Wittelsbacherplatz 2**
**D-8000 München 2 (DE)**

(72) Erfinder : **Dötzer, Richard, Dr.**
**Falkenhorst 14**
**D-8500 Nürnberg (DE)**
Erfinder : **Lechner, Ernst-Friedrich**
**Bissinger Strasse 31**
**D-8520 Erlangen (DE)**

## Beschreibung

Die Erfindung betrifft eine Leiterplatte entsprechend dem Oberbegriff des Patentanspruchs 1.

Die für die Halbleitertechnik und für die Elektronik bereitgestellten glasfaserverstärkten Epoxidharz-Leiterplatten und auch Leiterplatten aus gut wärmeableitenden Metallen mit isolierenden Lack- bzw. Kunststoffschichten oder Aluminiumoxidkeramik-Leiterplatten genügen vielfach nicht mehr den an sie gestellten Anforderungen, insbesondere im Hinblick auf die mechanische Festigkeit, den Wärmeabfluß oder die Flammfestigkeit.

Die Kühlung bzw. Entwärmung ist nur unzureichend und aufwendig durch oberflächliche Zwangsbelüftung der mit zusätzlichen Kühlkörpern versehenen Elektronikbausteine auf glasfaserverstärkten Epoxidharz-Leiterplatten mittels Luftgebläsen bei lokal sehr unterschiedlich wirksamen Strömungsgeschwindigkeiten von maximal zunächst 3 m/s, später sogar 6 m/s möglich. Auch wassergekühlte Flachbaugruppen zur Abführung der JOULEschen Wärme (= Verlustleistung), um die pro Einheit bis zu 2 W abgebenden Bauelemente unter 70 °C zu halten, befriedigen bezüglich Zuverlässigkeit und Betriebssicherheit nicht, weil auch ein nur kurzzeitiger oder lokaler Ausfall des Kühlsystems die Funktionalität des elektronischen Systems gefährdet und zu irreversiblen Schäden oder gar zum Ausfall der Gesamteinheit führen kann.

Die relativ teuren Aluminiumoxidkeramikplatten sind zwar noch bis zu Leiterplattenformaten von etwa 25 mm × 50 mm als Leiterbahnsubstrate verwendbar, bei größeren Formaten ist aber ihr Einsatz insbesondere im Hinblick auf die zu geringe mechanische Festigkeit (Brüchigkeit) und mangelnde Planität sehr begrenzt. Ein Einsatz von größeren Leiterplatten aus Aluminiumoxidkeramik scheitert meist an den Kosten.

Versuche mit Platten mit und ohne Bohrungen aus gut wärmeleitenden Metallen, überzogen mit isolierenden Lack- bzw. Kunststoffschichten, zeigen auch hier zahlreiche Nachteile auf. So sind die Lackschichten vor allem an den Lochkanten zu dünn, kleine Löcher setzen sich mit Lack oder Kunststoff zu, und es entstehen beim Kunststoff-Pulverbeschichten zu dicke Schichten, die sich bei den Löchern trichterförmig statt rechteckig einsenken. Wegen der besonders schlechten Wärmeleitfähigkeit von Isolierlacken und Kunststoffen wirken sich dickere Schichten für den lokalen Entwärmungsvorgang besonders nachteilig aus. Schließlich kommen noch die großen Haftfestigkeitsprobleme der Leiterbahn-Metallschichten auf den Lack- bzw. Kunststoffoberflächen hinzu.

Es sind ferner Substrate bekannt, bei denen auf eine eloxierte Aluminiumfolie eine sich in das Kristallgefüge der Eloxalschicht einlagernde, chemisch und thermisch resistente Schicht aufgesintert ist, die beispielsweise aus Aluminiumoxiden, Aluminiumsilikaten oder Glasfritten besteht. Solche Substrate weisen aber eine Oberflächenrauhigkeit und -porosität auf, die zum Aufbringen von feinstrukturierten, dünnen und eng tolerierten Schichten der Dünnfilmtechnik zu grob und damit ungeeignet ist.

Aus der DE-OS 1 809 919 ist ein Verfahren zur Herstellung von perforierten und temperaturstabilen Substraten mit sehr glatter Oberfläche unter Verwendung von eloxiertem Aluminium zum Aufbringen von feinstrukturierten, dünnen und eng tolerierten Gebilden aus Schichten der Dünnfilmtechnik bekannt. Dabei wird eine aus Aluminium oder einer Aluminiumlegierung bestehende Folie oder Platte durch Formätzen mit Durchbrüchen versehen, die geätzte Folie bzw. Platte anodisch hochglanzpoliert und kantenverrundet, die hochglanzpolierte Folie bzw. Platte harteloxiert und die harteloxierte Folie bzw. Platte versiegelt. Zur Herstellung gedruckter Schaltungen können durch Aufdampfen von Leitungszügen aus einem elektrisch leitenden Werkstoff weitere Schichten aufgebracht werden.

Aufgabe der Erfindung ist es, Leiterplatten zu schaffen, die die vorgenannten Nachteile nicht aufweisen und bei guter Wärmeableitung von den Bauelementen tiefere Betriebstemperaturen derselben und mithin höhere funktionelle Zuverlässigkeit und Lebensdauer sicherstellen, höhere mechanische Festigkeit und bessere Planität aufweisen und unbrennbar sind und dabei eine sichere Erdung und Abschirmung sowie eine gute elektromagnetische Verträglichkeit besitzen. Des weiteren sollen sie eine leichtere mechanische Herstellung mit einem besseren Korrosionsschutz der Oberflächenbeschichtung verbinden.

Diese Aufgabe wird bei Leiterplatten nach dem Oberbegriff des Patentanspruchs 1 erfindungsgemäß mit den Merkmalen des Kennzeichens des Patentanspruchs 1, die eine Galvano-Aluminium-Eloxalschicht beinhalten, gelöst. Ausgestaltungen und Weiterbildungen der Erfindung sind Gegenstand von Unteransprüchen.

Auf der Galvano-Aluminium-Eloxalschicht kann der Leiterbahnaufbau sowohl in Additiv- oder Subtraktivtechnik als auch mit dünner Isolier- bzw. Klebelack- und Dickfilmtechnik vorgenommen werden.

Die erfindungsgemäßen Leiterplatten sind gut wärmeleitend und ermöglichen dadurch eine rasche Abführung der durch Verlustleistung entstehenden JOULEschen Wärme der elektronischen Bausteine. Durch die raschere Entwärmung arbeiten die elektrischen und elektronischen Bauteile, die in der Halbleitertechnik und in der Industrieelektronik Verwendung finden, bei tieferen Betriebstemperaturen, was nicht nur ihre funktionelle Zuverlässigkeit, sondern auch ihre Lebensdauer erhoht. Durch den elektrisch leitenden Kern ermöglichen sie auch eine sichere Erdung und Abschirmung, was unter Nutzung des unmagnetischen Verhaltens der Galvano-Aluminium-Eloxalbeschichtung zu einer sehr guten elektromagnetischen Verträglichkeit (= EMV-Verhalten) führt. Sie weisen eine höhere mechanische Festigkeit verbunden mit einer besseren Planität auf, was auch größere Leiterplattenformate zuläßt, z. B. 340 mm × 360 mm, wie sie vor allem in der Meß-, Steuer- und Regelungstechnik benötigt werden. Sehr vorteilhaft sind des weiteren die besonderen Oberflächeneigenschaften des Galvano-Aluminium-Eloxals, wie elektrische Isolierung, vorzüglicher Haftgrund für Isolierlacke und Kleber sowie metallische und nichtmetallische Beschichtungen, beliebige Einfärbbar- und Bedruckbarkeit, hohe Oberflächenhärte und Abriebfestigkeit, gute Wärmeleitfähigkeit sowie ein hervorragendes Korrosionsschutzverhalten gegen die Atmosphärilien. Die erfindungsgemäßen Leiterplatten sind ferner unbrennbar. Einfachere Herstellung und leichtere mechanische Bearbeitbarkeit der Metallplatten mit geringerem Verschleiß der Bohrwerkzeuge gegenüber glasfaserverstärkten Epoxidharzplatten und Keramikplatten kommen den erfindungsgemäßen Leiterplatten ferner ebenso zugute wie bessere Maßhaltigkeit und Freiheit von Alterungserscheinungen.

Der Kern der erfindungsgemäßen gut wärmeableitenden Leiterplatten von vorzugsweise 1 bis 2 mm Dicke — mit und ohne Bohrungen — kann aus gut wärmeleitenden, mechanisch festen Metallen, beispielsweise Kupfer-, Aluminium-, Eisen-,Titan- und Buntmetallwerkstoffen, sowie in Sonderfällen aus Silber oder auch aus wärme- und elektrisch leitendem Graphit oder Kohlenstoff bestehen.

Die Erfindung wird durch eine Zeichnung veranschaulicht, die im Querschnitt wärmeableitende Leiterplatten 1 und 6 gemäß der Erfindung zeigt.

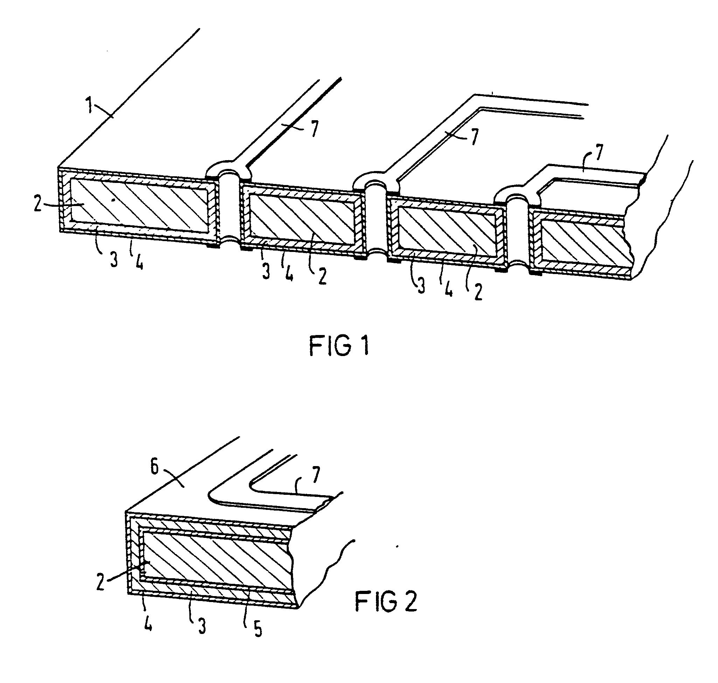

Fig. 1 zeigt einen Eisenkern 2 einer gelochten Leiterplatte 1, der mit einer 50 μm dicken Galvano-Aluminium-Eloxalschicht 3 und einer 5 μm dicken Polyimidschicht 4 überzogen ist.

Gemäß Fig. 2 ist der Kern 2 mit einer Kupferzwischenschicht 5 mit einer Dicke von 0,5 μm überzogen, auf welcher sich die Galvano-Aluminium-Eloxalschicht 3 und die Isolierlackschicht 4 befinden. Die Leiterbahnstruktur ist mit der Bezugsziffer 7 bezeichnet.

Die erfindungsgemäßen wärmeableitenden Leiterplatten werden aus plangeschliffenen, mit Bohrungen von beispielsweise 0,8 bis 1,2 mm Durchmesser versehenen, 1 bis 5 mm dicken Kernplatten der Oberflächenqualität 04 und 05 (nach DIN galvanisiergerecht) geschnitten, in einem Titanrahmen mit Spitzkontakten fixiert oder über Spannhaken aufgehängt und kontaktiert und dann oberflächenbehandelt und mit einer Galvano-Aluminium-Beschichtung versehen, entsprechend DE-PS 1 496 993, 2 122 610, 2 260 191, 2 537 256, 2 716 805 und 2 166 843 bzw. DE-OS 2 453 830 und 2 453 829.

Ein besonderer Vorteil der Galvano-Aluminium-Beschichtung ist infolge der guten Mikrostreufähigkeit der aprotischen Aluminierbäder — eine weitgehend gleichmäßige Beschichtung sowohl auf den Flächen als auch in den Bohrlochwandungen. Dies ist eine wesentliche Voraussetzung für die anschließende Anodisierung des aufgebrachten Galvano-Aluminiums zum isolierenden Galvano-Aluminium-Eloxal.

Zur Anodisierung können an sich bekannte Eloxierbäder eingesetzt werden, wie GS-, GSX-, GX- oder Harteloxierbäder. Dadurch wird eine elektrisch isolierende und gleichzeitig gut wärmeleitende Beschichtung der Kernplatten erhalten, die sich durch besonders hohe Härte (> 4 000 N/mm² HV) und entsprechende Abriebfestigkeit sowie hohe Resistenz gegen Atmosphärilien auszeichnen. Die so erzeugte Galvano-Aluminium-Eloxalschicht wird entweder in siedendem entionisiertem oder destilliertem Wasser oder in überhitztem Wasserdampf innerhalb 30 bis 60 min verdichtet und dadurch besonders korrosionsfest gemacht oder mit einem dünnen Isolierlackfilm überzogen.

Vor dem Verdichten kann die glasklar-transparente Galvano-Aluminium-Eloxalschicht — vermöge ihrer besonderen Feinstruktur durch Einfärbungen beliebig gekennzeichnet werden oder durch Bedruckungen konturenscharf beschriftet und dadurch charakterisiert werden, auch mehrfarbig. Auch kann durch Einlagerungen nicht leitfähiger, isolierender Substanzen, beispielsweise Kieselsäure, $Cr_2O_3$, $TiO_2$, $Al_2O_3$ etc., der Isolationswert verbessert werden.

Die erfindungsgemäßen wärmeableitenden Leiterplatten können mit Vorteil bei Einheiten mit hoher Packungsdichte der Bauelemente verwendet werden. Sie eignen sich besonders für die Anwendungen in der Industrieelektronik, wo es notwendig ist, Schwach- und Starkstrom-Bauelemente auf einer Platteneinheit zu kombinieren.

Die Erfindung wird durch die folgenden Beispiele noch näher erläutert.

Beispiel 1

a) Herstellung einer Galvano-Aluminium-Eloxalbeschichtung

Eine 2 mm dicke Platte aus Eisen (USt 1203) mit Bohrungen von 1,2 mm Durchmesser wird mit 4 Titan-Spitzkontakten über die Schmalseitenkanten in einem Titan-Rahmen (Warengestell) fixiert und zugleich kontaktiert. Die Abmessungen der Platte betragen 340 mm × 360 mm.

Zur Oberflächenbehandlung wird die Platte samt Rahmen in einem sauren Ätzbad (TRINORM « Fe »®, SCHERING AG/Berlin) abgeätzt, in Fließwasser gespült und in einem Entfettungsbad mit Unterkupferung allseitig mit 0,4 μm Kupfer beschichtet. Nach Spülen mit Wasser wird die unterkupferte Platte in einem Perchlorethylen-Dampfbad entwässert und getrocknet, in Toluol gespült und — noch toluolfeucht — in ein Galvano-Aluminierbad eingesenkt.

Zur Galvano-Aluminium-Beschichtung in aprotischen, sauerstoff- und wasserfreien aluminiumorganischen Komplexsalzelektrolytmedien wird das mit blanken Metallplatten bestückte Kathodengestell toluol- oder xylolfeucht über eine mit Inertgas ($N_2$ oder Ar) gefüllte Schleuse der Galvano-Aluminieranlage in den toluolverdünnten Elektrolyten eingesenkt. Unter Kathoden- und Elektrolytbewegung im 80 bis 100 °C heißen Bad wird mit der Galvano-Aluminium-Bechichtung begonnen. Je nach Substratmetall und später erforderlicher Galvano-Aluminium-Eloxal-Schichtdicke werden 50 μm Galvano-Aluminium allseitig (wenn gewünscht oder ausreichend auch einseitig) und homogen abgeschieden. Sehr wesentlich ist bei Leiterplatten, daß dank der guten Mikrostreufähigkeit der Galvano-Aluminierelektrolyte auch die Bohrlochinnenwandungen hinreichend gut und dick mit Galvano-Aluminium beschichtet werden, um anschließend eine einwandfreie Anodisierung zu ermöglichen. Kathodenbewegung und Elektrolytumwälzung müssen hierfür eine gute Durchströmung der Bohrlochkanäle herbeiführen. Die Elektrolytbewegung ist auch für die applizierbare Kathodenstromdichte ausschlaggebend, um eine Abscheidungsrate von 10 bis 20 μm Aluminium oder mehr pro Stunde sicherzustellen. Nach dem Abscheiden der gewünschten Galvano-Aluminium-Schichtdicke wird der Kathodenrahmen mit den galvano-aluminierten Metallplatten in die Schleuse hochgefahren, dort unter Inertgas eine Abspritzwäsche mit Toluol vorgenommen und dann das bestückte Kathodengestell aus der Schleuse genommen. Durch kurzzeitiges Tauchen in ein Beizbad, beispielsweise TRINORM « Al »$^8$, werden restlicher Elektrolyt und Hydrolyseprodukte aufgelöst, und nach dem Spülen in Fließwasser werden silberhelle, matt-blendfreie GalvanoAluminium-Beschichtungen erhalten.

Das Anodisieren des Galvano-Aluminiums zum Galvano-Aluminium-Eloxal erfolgt unmittelbar anschließend in einem GSX-Eloxierbad. Bei Metallkernsubstraten aus Kupfer-, Eisen- und Buntmetall- sowie Silberwerkstoffen kann nur ein mehr oder weniger großer Schichtanteil des aufgewachsenen Galvano-Aluminiums in Galvano-Aluminium-Eloxal überführt werden, während bei Aluminium- und Titanwerkstoffen das gesamte Galvano-Aluminium und — wenn wünschenswert — auch ein Teil des Substratwerkstoffes zu Galvano-Aluminium-Eloxal anodisiert werden kann. Die erhaltene Galvano-Aluminium-Eloxalschicht ist 60 μm dick, sie ist sehr hart und entsprechend abriebfest und wird anschließend in siedendem entionisiertem Wasser 30 bis 60 min lang verdichtet. Es wird eine besonders hohe Spannungsfestigkeit erreicht, die, falls erforderlich, durch einen zusätzlichen, aber dünnen Isolierlackfilm aus einem Polyimid erhöht werden kann.

b) Erzeugung einer Leiterbahnstruktur durch Additivtechnik

Die Galvano-Aluminium-Eloxaloberfläche wird mit Hilfe der an sich bekannten Photoresisttechnik mit der gewünschten Leiterbahnstruktur versehen. Die nach dem Ablösen der nichtausgehärteten Resistflächen blanken Oberflächenbereiche (Leiterbahnstrukturen) werden mittels eines stromlosen Kupfer- oder Nickelbades (chemische Verkupferung bzw. Vernickelung) beschichtet und die nur wenige μm dünnen Metallschichten in galvanischen Kupferbädern verstärkt. Zur Erzielung einer guten Lötfähigkeit werden die Leiterbahnstrukturen ganz oder partiell verzinnt. Schließlich wird der restliche ausgehärtete Photoresistfilm entfernt.

Beispiel 2

Auf einer nach Beispiel la hergestellten, Galvano-Aluminium-Eloxal-beschichteten Metallkern-Leiterplatte wird eine Leiterbahnstruktur

    b) durch Subtraktivtechnik erzeugt.

Hierzu wird die Galvano-Aluminium-Eloxaloberfläche zunächst allseitig stromlos verkupfert. Die nur wenige μm dünne Kupferschicht wird anschließend in einem galvanischen Kupferbad bis auf 15 bis 35 μm verstärkt. Dann wird mit Hilfe der an sich bekannten Photoresisttechnik die gewünschte Leiterbahnstruktur aufgebracht. Nach dem Belichten werden die Leiterbahnen freigelegt und die blanken Kupferoberflächen galvanisch verzinnt. Schließlich wird der verbliebene Resistfilm abgelöst und das freigelegte Kupfer weggeätzt, so daß die verzinnten Leiterbahnen und Lötaugen allein auf der Galvano-Aluminium-Eloxaloberfläche verbleiben.

## Patentansprüche

1. Leiterplatte mit einer eine Aluminium-Eloxalschicht aufweisenden planen Kernplatte aus elektrisch leitfähigem Werkstoff, dadurch gekennzeichnet, daß die Kernplatte (2) 1 bis 5 mm dick ist und eine durch Eloxieren einer Galvano-Aluminiumschicht entstandene Galvano-Aluminium-Eloxalschicht (3) mit einer Dicke von 10 bis 80 μm aufweist.

2. Leiterplatte nach Anspruch 1, dadurch gekennzeichnet, daß die Kernplatte (2) Bohrungen aufweist.

3. Leiterplatte nach Anspruch 1 oder 2, dadurch gekennzeichnet, daß sich zwischen der Kernplatte (2) und der Galvano-Aluminium-Eloxalschicht (3) eine 0,1 bis 2 μm dicke Schicht (5) aus Kupfer oder Silber befindet.

4. Leiterplatte nach einem der Ansprüche 1 bis 3, dadurch gekennzeichnet, daß die Kernplatte (2) aus Eisen, Aluminium oder Buntmetall besteht.

5. Leiterplatte nach einem der Ansprüche 1 bis 3, dadurch gekennzeichnet, daß die Kernplatte (2) aus leitfähigem Kohlenstoff oder Graphit besteht.

6. Leiterplatte nach einem oder mehreren der Ansprüche 1 bis 5, dadurch gekennzeichnet, daß die Galvano-Aluminium-Eloxalschicht (3) eine mittels Additivtechnik aufgebrachte Leiterbahnstruktur (7) aufweist.

7. Leiterplatte nach einem oder mehreren der Ansprüche 1 bis 5, dadurch gekennzeichnet, daß die Galvano-Aluminium-Eloxalschicht (3) eine mittels Subtraktivtechnik aufgebrachte Leiterbahnstruktur (7) aufweist.

## Claims

1. A printed circuit board having a flat core plate (2) of electrically conductive material with an anodised aluminium layer thereon, characterised in that the core plate (2) is 1 to 5 mm thick and has an anodised electro-deposited aluminium layer (3) with a thickness of from 10 to 80 µm formed by anodising an electro-deposited layer of aluminium.

2. A printed circuit board according to claim 1, characterised in that the core plate (2) has holes through it.

3. A printed circuit board according to claim 1 or claim 2, characterised in that there is a 0.1 to 2 µm thick layer (5) of copper or silver between the core plate (2) and the anodised electro-deposited aluminium layer (3).

4. A printed circuit board according to any one of claims 1 to 3, characterised in that the core plate (2) consists of iron, aluminium or nonferrous heavy metal.

5. A printed circuit board according to any one of claims 1 to 3, characterised in that the core plate (2) consists of conductive carbon or graphite.

6. A printed circuit board according to any one or more of claims 1 to 5, characterised in that the anodised electro-deposited aluminium layer (3) carries conductive paths (7) applied by an additive method.

7. A printed circuit board according to any one or more of claims 1 to 5, characterised in that the anodised electro-deposited aluminium layer (3) carries conductive paths (7) applied by a subtractive method.

**Revendications**

1. Plaquette à circuits imprimés comportant une plaque-noyau plane comportant une couche d'aluminium anodisé et constituée en un matériau électriquement conducteur, caractérisée par le fait que la plaque-noyau (2) possède une épaisseur comprise entre 1 à 5 mm et comporte une couche d'aluminium galvanique anodisé (3) formée par anodisation d'une couche d'aluminium galvanique et possédant une épaisseur comprise entre 10 et 80 µm.

2. Plaquette à circuits imprimés suivant la revendication 1, caractérisée par le fait que la plaque-noyau (2) comporte des perçages.

3. Plaquette à circuits imprimés suivant la revendication 1 ou 2, caractérisée par le fait qu'une couche (5) de cuivre ou d'argent possédant une épaisseur comprise entre 0,1 et 2 µm est disposée entre la plaque-noyau (2) et la couche d'aluminium galvanique anodisé (3).

4. Plaquette à circuits imprimés suivant l'une des revendications 1 à 3, caractérisée par le fait que la plaque-noyau (2) est réalisée en fer, en aluminium ou en un métal lourd non ferreux.

5. Plaquette à circuits imprimés suivant l'une des revendications 1 à 3, caractérisée par le fait que la plaque-noyau (2) est constituée par du carbone conducteur ou du graphite.

6. Plaquette à circuits imprimés suivant l'une ou plusieurs des revendications 1 à 5, caractérisée par le fait que la couche d'aluminium galvanique anodisé (3) possède une structure de voies conductrices (7) déposée au moyen de la technique additive.

7. Plaquette à circuits imprimés suivant l'une ou plusieurs des revendications 1 à 5, caractérisée par le fait que la couche d'aluminium galvanique anodisé (5) possède une structure de voies conductrices (7) déposée au moyen d'une technique soustractive.

FIG 1

FIG 2